**Europäisches Patentamt**

**European Patent Office**

**Office européen des brevets**

(19)

(11) Veröffentlichungsnummer: **0 206 133 B1**

# (12) EUROPÄISCHE PATENTSCHRIFT

(45) Veröffentlichungstag der Patentschrift: 31.07.91

(51) Int. Cl.⁵: **H01B 1/12**

(21) Anmeldenummer: **86107994.5**

(22) Anmeldetag: **11.06.86**

Die Akte enthält technische Angaben, die nach dem Eingang der Anmeldung eingereicht wurden und die nicht in dieser Patentschrift enthalten sind.

(54) **Verwendung von Polypyrrol zur Abscheidung von metallischem Kupfer auf elektrisch nichtleitende Materialen.**

(30) Priorität: 12.06.85 DE 3520980
05.10.85 DE 3535709

(43) Veröffentlichungstag der Anmeldung:
30.12.86 Patentblatt 86/52

(45) Bekanntmachung des Hinweises auf die Patenterteilung:
31.07.91 Patentblatt 91/31

(84) Benannte Vertragsstaaten:
**BE DE FR GB IT NL**

(56) Entgegenhaltungen:
**EP-A- 0 053 669**
**EP-A- 0 152 632**
**DE-A- 3 200 073**
**DE-A- 3 321 281**

(73) Patentinhaber: **BASF Aktiengesellschaft**
**Carl-Bosch-Strasse 38**
**W-6700 Ludwigshafen(DE)**

(72) Erfinder: **Naarmann, Herbert, Dr.**
**Haardtblick 15**
**W-6719 Wattenheim(DE)**
Erfinder: **Heckmann, Walter, Dr.**
**Geiersbergstrasse 2**
**W-6940 Weinheim(DE)**

# Beschreibung

Die Erfindung betrifft die Verwendung von Polypyrrol zur Abscheidung von metallischem Kupfer auf elektrisch nichtleitende Werkstoffe.

Nach einer Arbeit von K.C. Khulke und R.S. Mann, Journal of Polymer Science, Vol. 20 (1982), Seiten 1089 bis 1095 kann Pyrrol in wäßriger Lösung unter der Einwirkung von Oxidationsmitteln polymerisiert werden, so daS sich das Polymerisat in Form eines feinteiligen schwarzen Pulvers abscheidet. Diese Polymerisate eignen sich jedoch nur schlecht zur Beschichtung von anderen Materialien und haben daher kaum praktische Bedeutung erlangt.

Aufgabe der Erfindung war es, gut haftfähige Schichten aus metallischem Kupfer auf technisch einfache Weise auf elektrisch nichtleitende Werkstoffe aufzubringen.

Diese Aufgabe wird dadurch gelöst, daß man Elektrodenmaterialien, die dadurch erhalten worden sind, daß man auf einen elektrisch nichtleitenden Werkstoff entweder zunächst ein Oxidationsmittel und dann Pyrrol oder ein Oxidationsmtitel zusammen mit Pyrrol jeweils in Lösung aufgebracht und polymerisiert hat, zur Abscheidung von metallischem Kupfer verwendet.

Das Verfahren kann auf prinzipiell alle festen elektrisch nichtleitenden Substrate angewendet werden. Die Form der Materialien kann beliebig sein, so können die Materialien beispielsweise Dimensionen in einer Richtung haben, die ein vielfaches der Dimensionen quer dazu betragen. Die Materialien können z.B. in Form von Stäben, Bändern, Drähten oder Fasern vorliegen. Auch können die Materialien eine zweidimensionale Ausdehnung haben, die ein vielfaches der Dicke des Materials beträgt. So kann man z.B. auf Platten, Bahnen, Folien oder Filmen der Materialien Schichten aus leitfähigem Polymer aufbringen. Ebenso ist es möglich, die Schichten auf Materialien beliebiger Form, z.B. solcher wie sie technische Bauteile, Maschinenelemente oder Schaltelemente haben, aufzubringen.

Als Materialien eignen sich Nichtleiter, wie z.B. thermoplastische Kunststoffe, wie Polyoelfine, Polystyrol, Polyamide, Polyether, Polyurethane, Polyethersulfone, Polyimide oder Polyamidimide. Auch Polytetrafluorethylen, Polyester, Polyetherketone, Polysulfone und Polyetherimide können auf die erfindungsgemäße Weise beschichtet werden. Als nichtleitende Materialien kommen auch anorganische Materialien, wie z.B. Glas oder andere Silikatmaterialien in Frage. Weitere geeignete anorganische Materialien sind z.B. Ton, keramische Materialien, Titan-dioxid (Rutil, Anatas), Titanate und Einkristalle von Seignette-Salz. Die vorstehend erwähnten Titanate und Einkristalle von Seignette-Salz weisen eine ausgeprägte Anisotropie bestimmter Eigenschaften auf. Die Oberfläche dieser Materialien kann glatt oder offenporig sein, und es können sowohl kristalline als auch amorphe Materialien eingesetzt werden.

Als Oxidationsmittel verwendet man vorteilhaft Sauerstoff enthaltende Oxidationsmittel, die, bezogen auf 1 Mol Pyrrol in Mengen von 0,1 bis 2 Molen Verwendung finden können. Größere Mengen an Oxidationsmittel sind nicht erforderlich, da die Menge ausreicht, das gesamte Monomere in Polymere umzuwandeln.

Von den Oxidationsmitteln haben sich insbesondere Peroxosäuren und deren Salze, wie die Peroxodischwefelsäure und deren Alkali- und Ammoniumsalze bewährt. Vorzugsweise werden auch Peroxoborate, Perchlorate oder Peroxochromate wie Natriumperborat, Kaliumdichromat oder Eisenperchlorat und Kupferperchlorat verwendet. Außerdem sind Permanganate wie Kaliumpermanganat geeignet, wenn man diesem geringe Mengen Säure zusetzt. Auch Wasserstoffperoxid kann verwendet werden, wobei hier in der Regel die Anwesenheit von Leitsalzen sehr vorteilhaft ist. Auch $PbO_2$ oder Oxidationsmittel auf der Basis von Mn (III) können verwendet werden.

Man kann die Oxidationsmittel eventuell zusammen mit einem Leitsalz oder die Monomeren zusammen mit einem Leitsalz auf die Oberfläche des Materials aufbringen. Die Polymerisation der Monomeren kann also in Gegenwart von Leitsalzen erfolgen, die auch als Komplexierungsmittel oder Dotierungsmittel bezeichnet werden. Als Leitsalze haben sich z.B. $KHSO_4$, $Na_2SO_4$, HCOOH, $LiClO_4$, $HClO_4$, $Net_4ClO_4$, $NBu_4$, $ClO_4$, $KAlF_3$, $NaAlF_6$, $KBF_4$, $K_2ZrF_6$, $K_2NiF_4$, $HO_2(NO_3)_2$, $H_2SO_4$, $FeCl_3$, $NOPF_6$, $KAsF_6$ oder $NaPF_6$ bewährt. Die Konzentration der Leitsalze ist vorteilhaft so bemessen, daß auf 3 mol des eingesetzten Monomeren oder der Gemische der Monomeren mindestens 1 mol der oben aufgeführten Leitsalze verwendet werden; werden beispielsweise $FeCl_3$ oder $FeClO_4$ verwendet, so wirken solche Verbindungen gleichermaßen als Leitsalze und als Oxidationsmittel.

Gemäß einer bevorzugten Ausführungsform bringt man zunächst auf die Oberfläche des Materials ein Oxidationsmittel auf. Dieses erfolgt zweckmäßig in Lösung, wobei sich Wasser als Lösungsmittel gegebenenfalls in Abmischung mit organischen, mit Wasser mischbaren Lösungsmitteln bewährt hat. Es können aber auch organische Lösungsmittel, wie Dimethylsulfoxid, Methanol, Acetonitril, Ethylencarbonat, Propylencarbonat, Dioxan oder Tetrahydrofuran verwendet werden. Man arbeitet zweckmäßigerweise so, daß die Lösungen 0,1 bis 50 Gew.%, vorzugsweise 1 bis 20 Gew.% des Oxidationsmittels enthalten. Die Menge des zuzusetzenden Oxidationsmittels beträgt vorteilhaft von 0,1 bis 2 mol pro Mol der zu polymerisierenden Verbindung. Das Aufbringen des Pyrrols kann aus der Gasphase oder aus einer Lösung erfolgen. Beide Möglichkeiten werden später näher erläutert.

Gemäß einer weiteren bevorzugten Ausführungsform mischt man zunächst eine Lösung des Monomeren mit einer Lösung des Oxidationsmittels. Als Lösungsmittel eignen sich die bei der vorstehenden Verfahrensvariante erwähnten Lösungsmittel. Zur besseren Durchmischung bzw. zur Homogenisierung kann die Verteilung der Reaktionspartner in einem Ultraschallfeld erfolgen. Gegebenenfalls können auch Detergentien, vorzugsweise in einer Menge von 0.01 bis 10 Gew.% bezogen auf die eingesetzten Monomere, zugesetzt werden.

Zum Aufbringen der Schicht des Polypyrrols auf die anderen Materialien werden eine Lösung des Monomeren und eine Lösung des Oxidationsmittels, gegebenenfalls mit dem Leitsalz, gemischt und unmittelbar danach wird die Mischung auf die Oberfläche des Werkstoffs aufgebracht. Das Mischen der Lösung erfolgt zweckmäßig in einer für derartige Zwecke geeigneten Mischvorrichtung, wie Mischvorrichtungen für Zweikomponentenlacke oder solchen Mischvorrichtungen die als Zweikomponenten-Sprühvorrichtungen dienen. Vorteilhaft werden die Lösungen in feinteiliger Form gemischt und die Mischung auf die Oberfläche der Materialien aufgebracht. Unmittelbar nach dem Mischen, d.h. vorzugsweise in einem Zeitraum von 10 bis 180 Sekunden nach dem Mischen soll die Mischung auf der Oberfläche des Materials verteilt sein. Die vorteilhaft für derartige Arbeitsweisen zu verwendenden Zweikomponenten-Sprühvorrichtungen sind bekannt und in verschiedenen Varianten in der Technik gebräuchlich.

Ein Vorteil dieser Ausführungsform besteht darin, daß hiermit die kontinuierliche Beschichtung von Materialien mit Polypyrrol auf technisch sehr einfache Weise möglich ist, indem man die zu beschichtenden Materialien kontinuierlich an der verwendeten Spritz- bzw. Sprühvorrichtung vorbeiführt.

Das Pyrrol kann in einem Lösungsmittel, wie z.B. Ethanol oder einem Gemisch von Alkoholen mit Wasser, aber auch in Polymerlösungen, z.B. einer Lösung von Polyphenylsulfon in Dichlormethan eingesetzt werden. Die Konzentration des Monomeren, welche das elektrisch leitfähige Polymere liefert, beträgt zweckmäßigerweise 1 bis 25 Gew.%.

Die Konzentration von Oxidationsmittel und, gegebenenfalls, der Säure in der Lösung, die mit der Monomerlösung gemischt wird, beträgt im allgemeinen ebenfalls nicht mehr als 25 Gew.% (jeweils Oxidationsmittel und Säure).

Als Säuren, die der Lösung des Oxidationsmittel zugesetzt werden können, haben sich insbesondere organische Sulfonsäuren, z.B. Anthrachinonsulfonsäure und Phenylsulfonsäure sowie deren Derivate bewährt.

Aus den vorstehend geschilderten Verfahrensvarianten wird deutlich, daß im Falle der Verwendung eines Leitsalzes dieses der Lösung des Monomeren oder der Lösung des Oxidationsmittels oder der Mischung dieser beiden Lösungen zugesetzt werden kann.

Eine weitere Verfahrensvariante besteht darin, zunächst die Monomeren auf die Oberfläche der Materialien aufzubringen und anschließend das Oxidationsmittel.

In diesem Fall kann das zu beschichtende Material in einem Lösungsmittel, z.B. in Ethanol, Aceton oder Wasser, vorgelegt und mit den Monomeren getränkt werden. Durch Zugabe des Oxidationsmittels wird das Monomere anschließend in Polymere überführt.

Als Oxidationsmittel eignen sich die bereits für diesen Zweck vorstehend beschriebenen Verbindungen.

Das Material kann vor der Aufbringung der Monomeren gegebenenfalls einer Behandlung, z.B. mit Säure, unterworfen werden, um die Haftung der Monomeren am Material zu erhöhen.

Bei den Verfahrensvarianten, in denen Oxidationsmittel und/oder Leitsalz und Monomere in zeitlichem Abstand voneinander auf das Material aufgebracht werden, d.h. zunächst das Oxidationsmittel und anschließend die Monomeren oder zunächst die Monomeren und anschließend das Oxidationsmittel, ist es grundsätzlich möglich, die Monomeren aus der Gasphase oder aus einer Lösung aufzubringen. Häufig hat sich die Aufbringung aus der Gasphase als vorteilhaft erwiesen.

Vorteilhaft erfolgt die Aufbringung aus der Gasphase derart, daß man die zu beschichtenden Materialien (behandelt oder unbehandelt; vor oder nach Aufbringung von Oxidationsmittel und/oder Leitsalz) in ein Gefäß überführt, dieses evakuiert und anschließend das Material mit Monomerdämpfen behandelt. In jedem Fall ist es beim Aufbringen der Monomeren aus der Gasphase von Vorteil, eventuell noch von der Behandlung des Materials vorhandene Lösungsmittel vollständig zu entfernen.

Als Lösungsmittel für die Variante der Aufbringung der Monomeren aus einer Lösung haben sich vor allem wäßrige und alkoholische Lösungsmittel, Ether, Tetrahydrofuran und Aceton bewährt, um nur einige zu nennen.

Die Dicke der auf den Materialien aufgebrachten Schichten aus elektrisch leitfähigen Polymeren ist in weiten Grenzen variabel, liegt im allgemeinen jedoch im Bereich von 0,1 bis 100 µm. Für spezielle Anwendungen können die Schichten jedoch sowohl dicker als auch dünner sein.

Die Polymerisation der Monomeren erfolgt in einem Temperaturbereich von 0 bis 500°C, vorzugsweise zwischen 20 und 250°C.

Der Druck, bei dem die Polymerisation durchgeführt wird, ist an sich nicht kritisch. Zweckmäßigerweise arbeitet man bei einem Druck im Bereich von 10 kPa bis 100 MPa.

Die elektrische Leitfähigkeit der aufgebrachten Polymeren liegt im allgemeinen im Bereich von $10^{-7}$ bis $10^{+2}$ $Scm^{-1}$, insbesondere im Bereich von $10^{-3}$ bis 10 $Scm^{-1}$.

Man kann nach dem erfindungsgemäßen Verfahren die Schicht des leitfähigen Polymeren nur auf bestimmte Stellen des Materials aufbringen, kann also Muster, Bilder oder Schriftzeichen bzw. Schaltanordnungen auf den Werkstoff aufbringen. Genauso ist es möglich, den gesamten Werkstoff nach dem Verfahren mit einer leitfähigen polymeren Schicht zu versehen. Mitunter ist es angebracht, diesen Vorgang mehrfach zu wiederholen, wobei unterschiedliche leitfähige Polymere übereinander gelagert werden können. Wie bereits erwähnt, haftet die Schicht des leitfähigen Polymeren fest auf der Schicht des Materials. Eine Verbesserung der Haftfestigkeit der elektrisch leitfähigen Schicht auf den Materialien wird in vielen Fällen durch Tempern bei 80 bis 150°C (natürlich in Abhängigkeit von der Erweichungstemperatur des zu beschichtenden Materials) erreicht.

Die nach dem obigen Verfahren erhaltenen Materialien werden erfindungsgemäß als Elektrodenmaterial bei der Abscheidung von metallischem kupfer verwendet.

Beispiel

Die Oberfläche eines Polyesterfilms (42 $\mu$m dick) wurde mit einer 10 gew.%igen ethanolischen Lösung von Eisenperchlorat bestrichen. Man ließ das Lösungsmittel abdampfen und setzte den so behandelten Film bei einer Temperatur von 150°C 30 Sekunden einer Stickstoffatmosphäre aus, die 10 Vol.% Pyrroldampf enthielt. Innerhalb weniger Sekunden bildete sich an der Filmoberfläche eine schwarze Schicht aus. Dieser unlösliche Polypyrrolüberzug hatte eine spezifische Leitfähigkeit von $10^{-1}$ S/cm.

**Patentansprüche**

1. Verwendung von Elektrodenmaterialien, die dadurch erhalten worden sind, daß man auf einen elektrisch nichtleitenden Werkstoff entweder zunächst ein Oxidationsmittel und dann Pyrrol oder ein Oxidationsmittel zusammen mit Pyrrol jeweils in Lösung aufgebracht und polymerisiert hat, zur Abscheidung von metallischem Kupfer.

**Claims**

1. Use of electrode materials obtained by an oxidizing agent having been applied to an electrically non-conducting material either followed by pyrrole or together with pyrrole, in either case from solution, and having been polymerized, for depositing metallic copper.

**Revendications**

1. Utilisation, en vue du dépôt de cuivre métallique, de matières servant d'électrodes, en vue du dépôt de cuivre métallique, que l'on a obtenues par l'application et la polymérisation sur un matériau non conducteur de l'électricité, soit d'abord d'un agent d'oxydation et ensuite du pyrrole, soit d'un agent d'oxydation en même temps que du pyrrole, à chaque fois en solution.